# EUROPEAN PATENT SPECIFICATION

(11) **EP 4 203 033 B1**
(45) Date of publication and mention of the grant of the patent: **25.02.2026**
(21) Application number: 22205187.2
(22) Date of filing: 03.11.2022
(51) Int. Cl.: H10D 89/60, H02H 9/04, H01L 23/522

(54) **ELECTROSTATIC DISCHARGE (ESD) CIRCUIT WITH DIODES IN METAL LAYERS OF A SUBSTRATE**
SCHALTUNG ZUR ELEKTROSTATISCHEN ENTLADUNG (ESD) MIT DIODEN IN METALLSCHICHTEN EINES SUBSTRATS
CIRCUIT DE DÉCHARGE ÉLECTROSTATIQUE (ESD) AVEC DIODES DANS DES COUCHES MÉTALLIQUES D'UN SUBSTRAT

(30) Priority: 22.12.2021 US 202117559886
(43) Date of publication of application: 28.06.2023
(73) Proprietor: INTEL Corporation, Santa Clara, CA 95054 (US)
(72) Inventor: CHANG, Yao-Feng, Hillsboro, 97123 (US)
(74) Representative: Goddar, Heinz J.

(56) References cited:
- US-A1- 2016 240 527
- US-A1- 2019 304 963
- US-A1- 2021 193 645
- US-B1- 9 397 084

## Description

### FIELD

Embodiments of the present disclosure generally relate to the field of semiconductor packaging, and in particular to electrostatic discharge (ESD) circuits in a package.

### BACKGROUND

Continued growth in virtual machines, cloud computing, and portable devices will continue to increase the demand for high density and high quality transistors operation within chips and packages.

US 9 397 084 B1 describes a structure of ESD protection circuits on a BEOL layer including a substrate. A plurality of interconnect layers and an inter-level dielectric layer are disposed on the substrate. The inter-level dielectric layer is disposed between the plurality of interconnect layers. The last layer of the interconnect layers comprises an I/O pad, a first pad and a second pad. A first diode and a second diode are disposed on the last layer of the inter-level dielectric layer, wherein the first diode electrically connects to the I/O pad and the first pad and the second diode electrically connects to the I/O pad and the second pad.

US 2019/304963 A1 describes a backend electrostatic discharge (ESD) diode device structure comprising: a first structure comprising a first material, wherein the first material includes metal; a second structure adjacent to the first structure, wherein the second structure comprises a second material, wherein the second material includes a semiconductor or an oxide; and a third structure adjacent to the second structure, wherein the third structure comprises of the first material, wherein the second structure is between the first and third structures.

US 2021/193645 A1 describes a die with a front-end and a backend. The front-end may include a transistor. The backend may include a signal line, a conductive line, and a diode that is communicatively coupled with the signal line and the conductive line. Other embodiments may be described or claimed.

US 2016/240527 A1 describes an apparatus including a substrate and an interposer associated with the substrate. The apparatus further includes a first device disposed within the substrate or within the interposer and a second device disposed within the interposer. The first device and the second device are arranged in a stacked configuration.

The invention is set forth in the independent claims. Embodiments of the description are described in the dependent claims.

### BRIEF DESCRIPTION OF THE DRAWINGS

FIG. 1 includes a schematic of a legacy ESD implementation that includes a transistor.
FIG. 2 includes schematics of additional legacy ESD implementations.
FIG. 3 includes a schematic and side view illustrations of an ESD protection circuit with diodes in a metal layer of a substrate, in accordance with various embodiments.
FIG. 4 includes a schematic and side view illustrations of an implementation of a diode in a metal layer of a substrate used in an ESD protection circuit, in accordance with various embodiments.
FIGs. 5A-5D illustrate graphs of various characteristics of diodes in a metal layer, in accordance with various embodiments.
FIG. 6 includes a schematic and side view illustrations of a chip with an integrated fuse element for detecting ESD event levels, in accordance with various embodiments.
FIG. 7 illustrates an example process for manufacturing a transistor structure with a monolayer edge contact, in accordance with various embodiments.
FIG. 8 illustrates a computing device in accordance with one implementation of the invention.
FIG. 9 illustrates an interposer that includes one or more embodiments of the invention.

### DETAILED DESCRIPTION

Embodiments described herein may be related to apparatuses, processes, and techniques directed to an ESD protection circuit that includes diodes between a metal 2 layer and a metal 4 layer of a substrate by plug and via connection. In embodiments, the diodes may be metal-semiconductor-metal (MSM) diodes. In embodiments, the ESD protection circuit may be formed into a substrate, where the MSM diodes are formed as part of the back end of line (BEOL) process used to form metal layers.

Portions of the ESD protection circuit may be proximate to a layer of one or more circuits, which may include transistor circuits that are within the substrate or coupled with the substrate. In embodiments, these circuits may be formed as part of a front end of line (FEOL) manufacturing process. In embodiments, the ESD protection circuit may be fully integrated with the BEOL process. In embodiments, ESD event detection may also be enabled by examining the state of various fuses to check a level of an ESD event that may have occurred during assembly and/or handling of a device that includes the substrate.

In comparison with legacy ESD implementations, embodiments described herein will not increase circuit design and architecture floorplan complexity. In addition, no front end (FE) process will be used here, thus decreasing the fabrication cost per wafer. For example, there will be no doping process, no diffusion (n-doped and p-doped), thermal annealing, and shallow trench isolation (STI). In addition, embodiments will consume less area of silicon, for example 6F² vs. 4F² design area for CMOS and MSM diode, respectively), and result in improved circuit design capability and area efficiency, including 3D architecture design capability.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

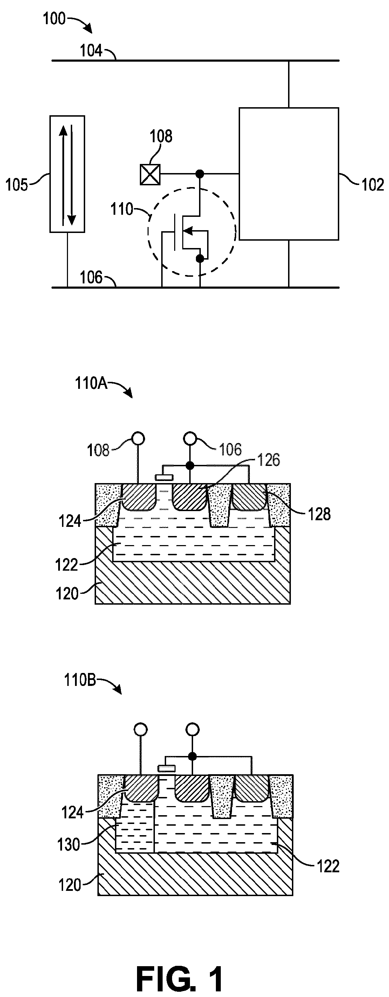

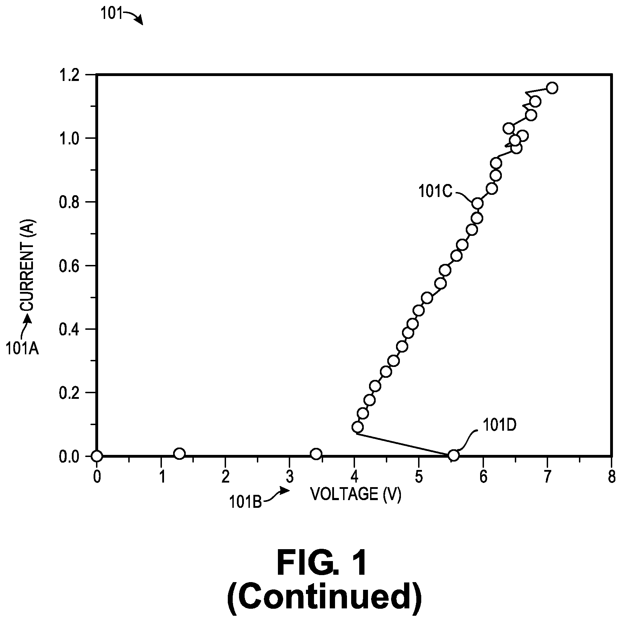

FIG. 1 includes a schematic of a legacy ESD implementation that includes a transistor. Legacy grounded-gate NMOS (GGNMOS) 100 shows a schematic of a legacy example of an ESD protection circuit that uses complementary metal oxide semiconductor (CMOS) technology. This may be referred to as a type I ESD protection circuit. A circuit to be protected 102, which may also be referred to as an internal circuit, is electrically coupled to a voltage drain drain (Vdd) 104 and a voltage source source (Vss) 106. The Vdd 104 and Vss 106 are coupled using a power-rail clamp circuit 105. The circuit to be protected 102, an input/output (I/O) pad 108, and the Vss 106 are electrically coupled with the GGNMOS 110. The GGNMOS 110 is grounded to keep it off during normal circuit operation, but will turn on as the positive voltage excursions above a trigger voltage (Vt1) 101D occur. Diagram 101 shows a positive I-V curve of the GGNMOS 110 with a W=120 µm implemented in 0.18 µm CMOS technology, with the current axis 101A, a voltage axis 101B, and curve 101C. Diagram 101 shows a measurement by a transmission-line-pulsing (TLP) system. As shown, a snap-back I-V curve in an S-shape may be observed in diagram 101.

GGNMOS 110A is a cross section side view of an example of GGNMOS 110, which is a single-finger device. GGNMOS 110A includes a P-substrate 120 at the bottom, and a P-well 122 directly above. A first N+ region 124 may be electrically coupled with the I/O pad 108. A second N+ region 126 may be electrically coupled with a P+ region 128, which may both be electrically coupled with the Vss 106. In implementations, GGNMOS 110A may be drawn in a multi-finger structure (not shown) with a central drain to save total layout area, which may be implemented by combining single-finger structures with sharing drain and source regions between every two adjacent fingers.

GGNMOS 110B, which may be similar to GGNMOS 110A, is a cross section side view of an example GGNMOS 110, where an N-well implant 130 is placed below the first N+ region 124 in order to reduce bottom capacitance with the given *Lₙ* capacitance thus speeding up the switching. As a result, most of the bottom N+ 124/ P-well 122 capacitance will then be replaced by an N-well 130 /P-well 122 sidewall capacitance and N-well 130 /P-substrate 120 bottom PN capacitance.

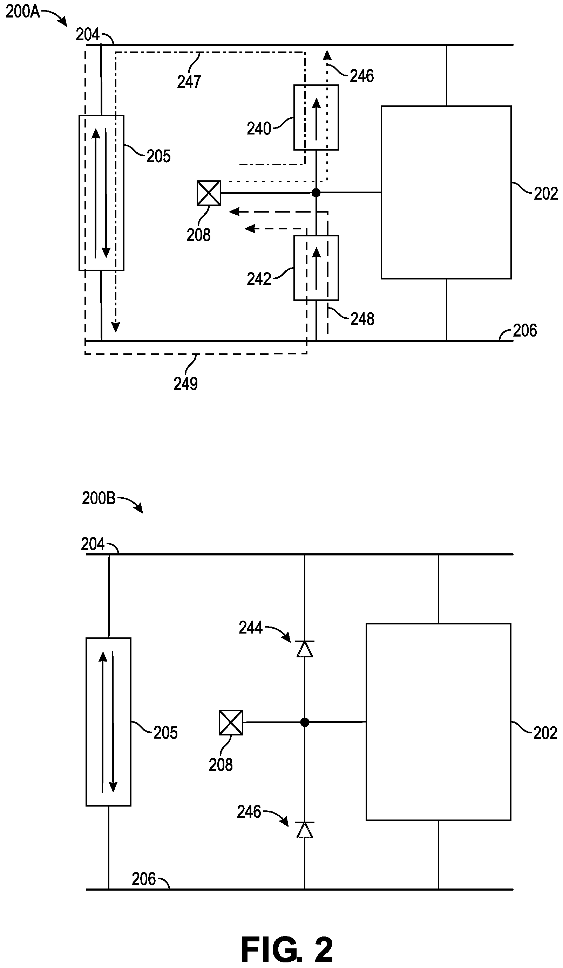

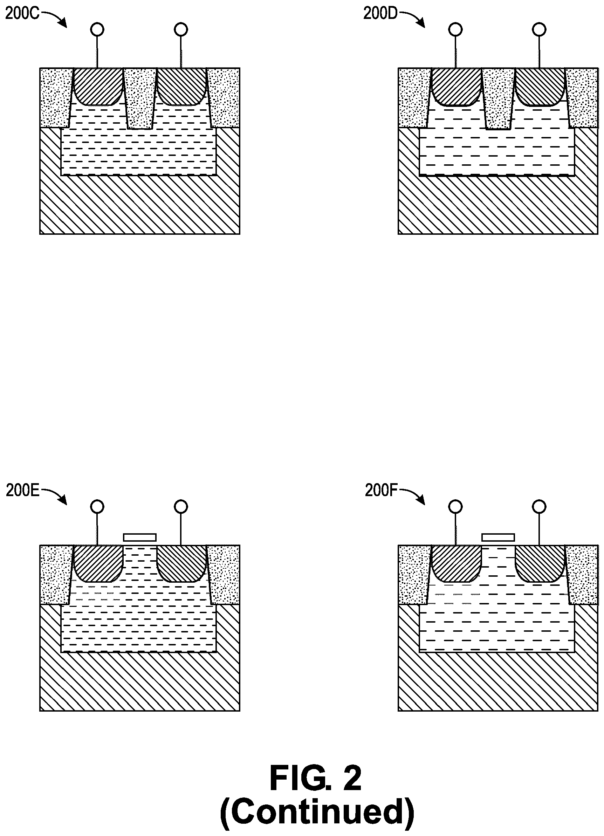

FIG. 2 includes schematics of additional legacy ESD implementations. These implementations are examples of type II ESD protection circuits. Unlike the implementation in FIG. 1, the ESD implementations in FIG. 2 includes two unidirectional ESD protection devices from I/O pad 208 to Vdd 204, and from Vss 206 to I/O pad 208.

Schematic 200A shows a circuit to be protected 202 that is electrically coupled to a Vdd 204 and a Vss 206. A legacy whole-chip ESD protection design must provide the ESD current paths of all possible combinations, including the positive I/O-to-VDD (PD), positive I/O-to-VSS (PS), negative I/O-to-VDD (ND), and negative I/O-to-VSS (NS). A first ESD protection device 240 is placed between the I/O pad 208 and the Vdd 204, and a second ESD protection device 242 is placed between the I/O pad 208 and the Vss 206. Both the PD ESD current 246 and the NS ESD current 248 can be discharged through one unidirectional ESD protection device 240, 242. The PS ESD current 247 and the ND ESD current 249 may be discharged through one ESD protection device and the power rail ESD clamp circuit 205. In embodiments, the ESD protection devices 240, 242 may be diodes.

Schematic 200B shows a dual-diode ESD protection circuit for high-frequency applications. A circuit to be protected 202 that is electrically coupled to a Vdd 204 and a Vss 206. A first diode 244 is placed between the I/O pad 208 and the Vdd 204, and a second diode 246 is placed between the I/O pad 208 and the Vss 206. A turn-on inefficient power rail ESD clamp circuit 205 electrically couples with the Vdd 204 and Vss 206. In implementation, the two ESD diodes 244, 246 are cooperated with the turn-on efficient power rail ESD clamp circuit 205 to discharged ESD current in a forward-biased condition.

In the CMOS process, a choice for ESD protection diodes includes P+/N-well, N+/P-well, and N-well/P-well diodes. Diodes 200C-200F are cross-section side views of diodes. Diode 200C is a cross section side view of a P+/N-well diode, which may be similar to diode 244 that is used between I/O pad 208 and the Vdd 204. In implementations, diode 200C may be STI-bounded. Diode 200D is an N+/P-well diode, which may be similar to diode 246 and be used between Vss 206 and I/O pad 208. Implementations, diode 200D may be STI-bounded. Diode 200e is an example of a gate bounded P+/N-well diode, and diode 200F is an example of a gate bounded N+/P-well diode.

With respect to the legacy implementations in FIGs. 1-2, the GGNMOS 110, and diodes 110A, 110B, 240, 242, 244, 246, 200C, 200D, 200E, 200F are implemented as part of the front end of line processes during fabrication, where the fabrication cost per wafer is very high typically due to request doping, diffusion (both n and p), annealing, and STI. In addition, these legacy implementations consume a lot of silicon area, and hinder 3D architecture design capability.

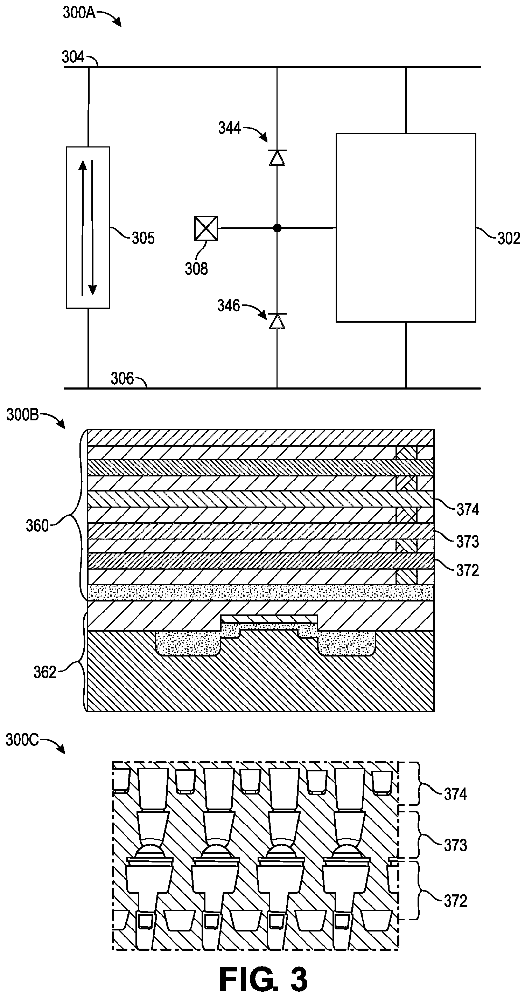

FIG. 3 includes a schematic and side view illustrations of an ESD protection circuit with diodes in a metal layer of a substrate, in accordance with various embodiments. Schematic 300A shows a dual-diode ESD protection circuit. A circuit to be protected 302 is electrically coupled to a Vdd 304 and a Vss 306. A first diode 344 is placed between the I/O pad 308 and the Vdd 304, and a second diode 346 is placed between the I/O pad 308 and the Vss 306. A power rail ESD clamp circuit 305 electrically couples with the Vdd 304 and Vss 306.

Substrate 300B is a cross section side view of an illustration of a substrate that includes a plurality of metal layers 360 that are formed as part of a BEOL process of substrate formation, and includes layers 362 that are part of a FEOL process of substrate formation. In embodiments, the ESD diodes 344, 346 may be placed within one or more metal layers 360. For example, the ESD diodes 344, 346 may be placed at metal 3 layer 373, between metal 4 layer 374 and metal 2 layer 372. Diagram 300C shows an example TEM cross section of MSM implementation of diodes 344, 346 in metal layer 3 373.

According to the claimed invention, the ESD diodes 344, 346 are MSM diodes, where the semiconductor is amorphous silicon. In other examples, not falling within the scope of the claimed invention, the semiconductor may include an oxide semiconductor or an amorphous semiconductor. As a result, functionality of the ESD diodes 344, 346 may be fully integrated into the BEOL process for ESD protection circuit design. As a result, in embodiments, ESD may not increase the fabrication cost per wafer. For example, in embodiments there may be no doping process, diffusion (n-doped and p-doped), thermal annealing, or STI that would otherwise be required for manufacturing transistors in legacy implementations as described above with respect to FIGs. 1-2.

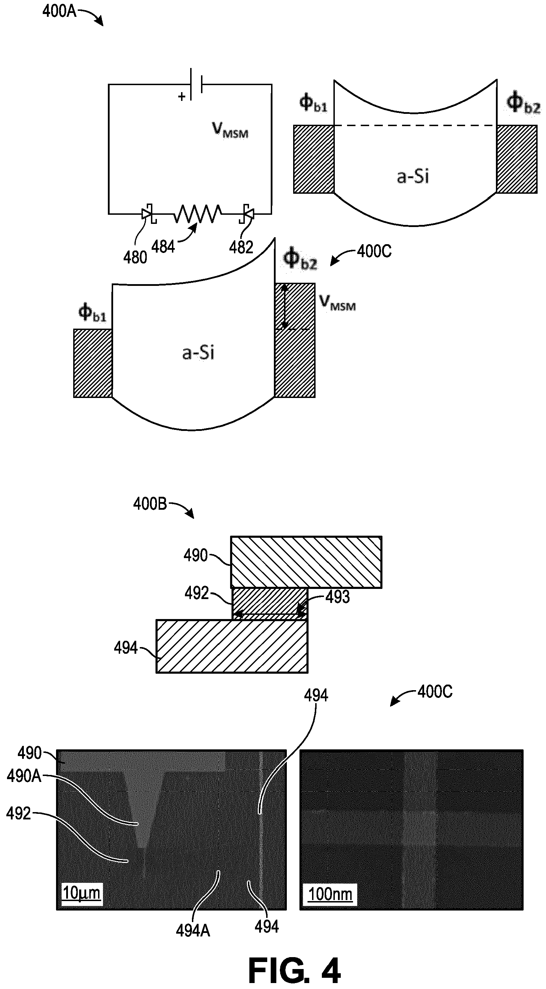

FIG. 4 includes a schematic and side view illustrations of an implementation of a diode in a metal layer of a substrate used in an ESD protection circuit, in accordance with various embodiments. Equivalent circuit diagram 400a illustrates a series resistance and a MSM diode, for example diode 344, 346 of FIG. 3, where band diagrams at equilibrium and forward bias on D1 480 is shown. Series resistance is labeled as RS 484. The symbols φ_{b1} and φ_{b2} represent Schottky barrier height at D₁ 480 and D₂ 482.

MSM diode 400b, which may be similar to diode 344, 346 of FIG. 3, shows an example diode that may be constructed in a metal layers such as one of the metal layers 360 of FIG. 3. According to the claimed invention, MSM diode 400b has a first metal layer 490 of tellurium (TE), a semiconductor layer 492 of amorphous silicon, and a second metal layer 494 of beryllium (BE). The structure of the MSM diode 400b has an effective area 493.

MSM diode 400c, which may be similar to diode 400b, includes a crossbar shape of the semiconductor layer 492 that is designed to minimize impacts on parasitic components. In addition, the metal lines 490A, 494A are tapered to reduce parasitic capacitance.

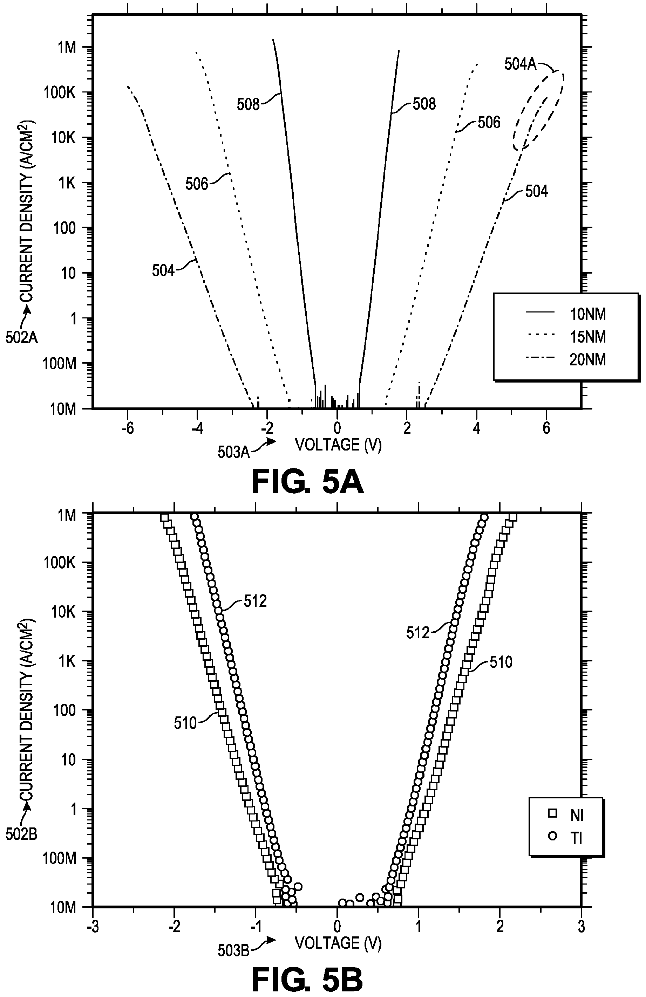

FIGs. 5A-5D illustrate graphs of various characteristics of diodes in a metal layer, in accordance with various embodiments. FIG. 5A illustrates a semi-log plot of current densities 502A versus voltage 503A characteristics of different thicknesses of MSM diode layers of titanium, amorphous silicon, and titanium. A 20 nm thickness 504, a 15 nm thickness 506 and a 10 nm thickness 508 is shown. The dashed circle 504A and area with 20 nm thickness where a series resistance affect becomes more prominent.

FIG. 5B illustrates a semi-log plot of current densities 502B versus voltage 503B characteristics of a titanium, amorphous silicon, titanium MSM diode 512 versus a nickel, amorphous silicon, nickel MSM diode 510, where a thickness of the amorphous silicon is 10 nm. As her shown, the titanium MSM diode has a higher current density than the nickel MSM diode at a same thickness of amorphous silicon, which implies the amorphous silicon is unintentionally doped with n-type impurities. For n-type silicon, nickel tends to pin closer to the valence band of silicon, while titanium is pinned at midgap, resulting in a lower current density for the nickel MSM diode.

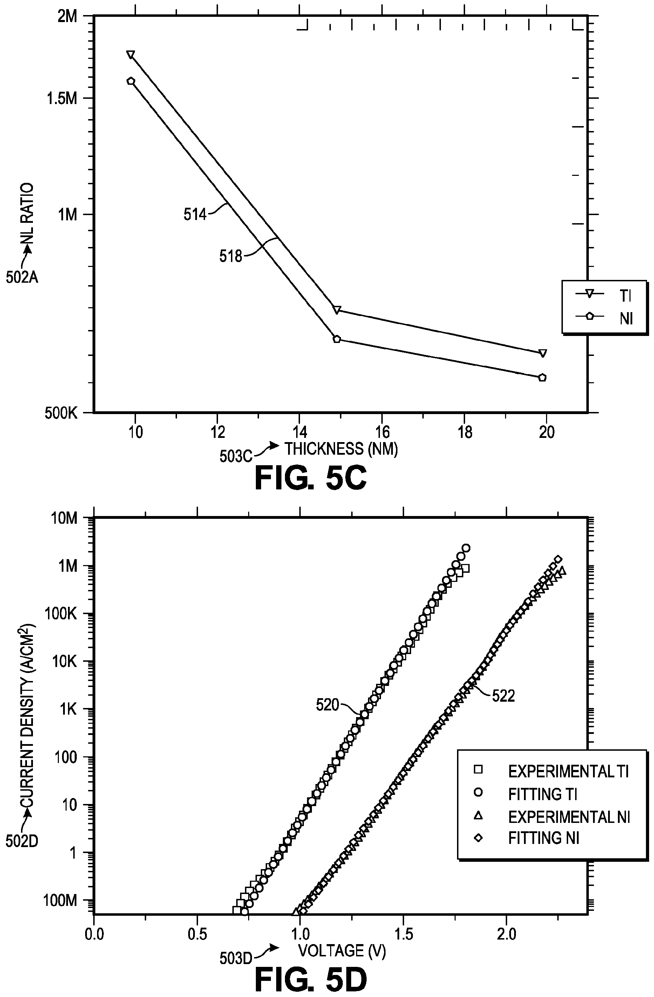

FIG. 5C illustrates comparison nonlinear (NL) ratio 502A between a titanium, amorphous silicon, titanium MSM diode 518, and a nickel, amorphous silicon, nickel MSM diode 514 at different thicknesses 503C. The illustration indicates that series resistance plays an important role when designing high current density diode. There is asymmetry of current density between each polarity for titanium and nickel MSM diodes. Amorphous silicon and electrodes weren't deposited in the same instrument or same vacuum environment. So this causes inevitable interface difference between two Schottky diodes.

FIG. 5D illustrates a semi-log plot of current densities 502D versus voltage 503D characteristics of a titanium, amorphous silicon, titanium MSM diode 520 versus a nickel, amorphous silicon, nickel MSM diode 522. The Schottky barrier height between titanium and amorphous silicon is ≈0.79 eV, and the Schottky barrier height between nickel and amorphous silicon is about 0.86 eV. Note that the bandgap of hydrogenated amorphous silicon is around 1.6-1.8 eV. The ideality factor are 1.18 and 1.36 for titanium and nickel respectively. FIGs. 5A-5D show a nice MSM diode characterization and good match with the conventional diode performance, but less cost with improved circuit design capability and area efficiency.

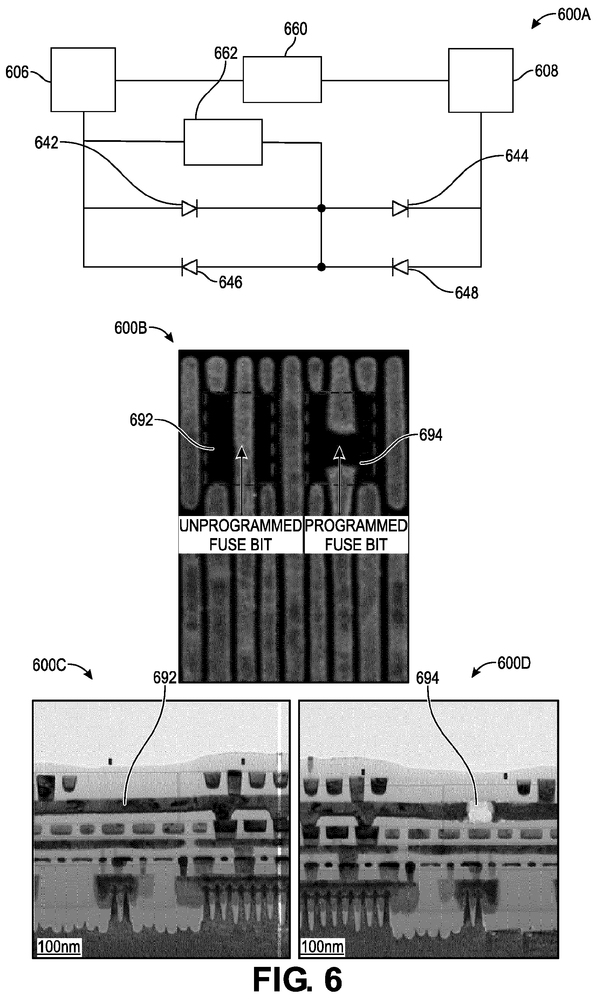

FIG. 6 includes a schematic and side view illustrations of a chip with an integrated fuse element for detecting ESD event levels, in accordance with various embodiments. ESD protection circuit 600A includes a Vss pad 606, and an I/O pad 608, which may be similar to Vss 306 and I/O pad 308 of FIG. 3. An anode of a first diode 642 may be electrically coupled with the Vss pad 606. An anode of a second diode 644 may be electrically coupled with a cathode of the first diode 642. A cathode of a third diode 646 may be electrically coupled with the Vss pad 606. A cathode of a fourth diode 648 electrically coupled with an anode of the third diode. The I/O pad 608 may be electrically coupled with a cathode of the second diode 644 and with an anode of the fourth diode 648.

In embodiments, a first fuse 660 may be electrically coupled between the Vss pad 606 and the I/O pad 608. A second fuse 662 may be electrically coupled between the Vss pad 606 and the cathode of the first diode 642 and the anode of the third diode 646. During operation, excess current through either the first fuse 660 or the second fuse 662 may cause the respective fuses to blow, and created an interruption in the circuit. In embodiments, the first fuse a 660, the second fuse 662, and the diodes 642, 644, 646, 648 may be in a metal layer of a substrate, for example a metal layer within the plurality of metal layers 360 of FIG. 3.

Diagram 600B shows a top view of a scanning electron microscope (SEM) image of a metal 3 layer, which may be similar to metal 3 layer 373 of FIG. 3 that includes a first fuse 692 and a second fuse 694, which may be similar to first fuse 660 and second fuse 662. The first fuse 692 is intact and has not blown. The second fuse 694 has a metal discontinuity resulting from the second fuse 694 having blown.

Diagram 600C shows a cross-section side view of the metal 3 layer showing fuse 692 that in intact, and diagram 600D shows a cross section side view of the metal 3 layer showing fuse 694 that has blown.

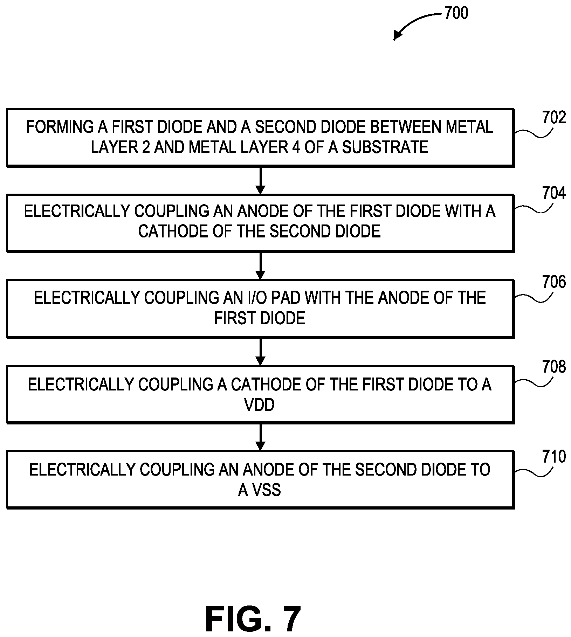

FIG. 7 illustrates an example process for manufacturing a transistor structure with a monolayer edge contact, in accordance with various embodiments.

At block 702, the process may include forming a first diode and a second diode between metal layer 2 and metal layer 4 of a substrate. In embodiments, the first diode in the second diode may be similar to first diode 344 and second diode 346 of FIG. 3. In embodiments, metal layer 2 and metal layer 4 may be similar to metal layer 372 and metal layer 374 of FIG. 3.

At block 704, the process may further include electrically coupling an anode of the first diode with a cathode of the second diode.

At block 706, the process may further include electrically coupling an I/O pad with the anode of the first diode. In embodiments, the I/O pad may be similar to I/O pad 308 of FIG. 3.

At block 708, the process may further include electrically coupling a cathode of the first diode to a Vdd. In embodiments, the Vdd may be similar to Vdd 304 of FIG. 3.

At block 710, the process may further include electrically coupling an anode of the second diode to a Vss. In embodiments, the Vss may be similar to Vss 306 of FIG. 3.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or gate-all-around transistors such as nanoribbon and nanowire transistors. Although the implementations described herein may illustrate only Finfet transistors, it should be noted that the invention may also be carried out using planar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO₂) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. And in further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

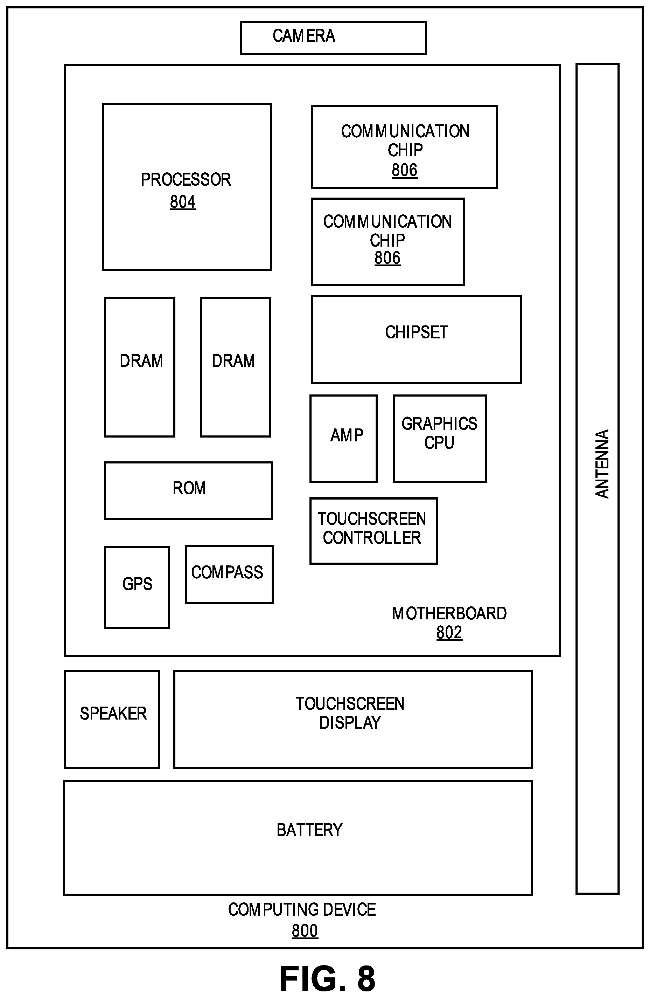

FIG. 8 illustrates a computing device 800 in accordance with one implementation of the invention. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

Depending on its applications, computing device 800 may include other components that may or may not be physically and electrically coupled to the board 802. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of the invention, the integrated circuit die of the communication chip includes one or more devices, such as MOS-FET transistors built in accordance with implementations of the invention.

In further implementations, another component housed within the computing device 800 may contain an integrated circuit die that includes one or more devices, such as MOS-FET transistors built in accordance with implementations of the invention.

In various implementations, the computing device 800 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 800 may be any other electronic device that processes data.

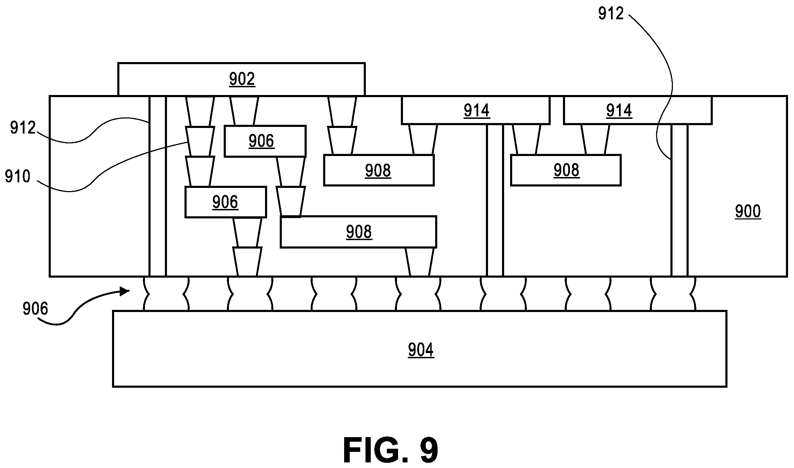

FIG. 9 illustrates an interposer 900 that includes one or more embodiments of the invention. The interposer 900 is an intervening substrate used to bridge a first substrate 902 to a second substrate 904. The first substrate 902 may be, for instance, an integrated circuit die. The second substrate 904 may be, for instance, a memory module, a computer motherboard, or another integrated circuit die. Generally, the purpose of an interposer 900 is to spread a connection to a wider pitch or to reroute a connection to a different connection. For example, an interposer 900 may couple an integrated circuit die to a ball grid array (BGA) 906 that can subsequently be coupled to the second substrate 904. In some embodiments, the first and second substrates 902/904 are attached to opposing sides of the interposer 900. In other embodiments, the first and second substrates 902/904 are attached to the same side of the interposer 900. And in further embodiments, three or more substrates are interconnected by way of the interposer 900.

The interposer 900 may be formed of an epoxy resin, a fiberglass-reinforced epoxy resin, a ceramic material, or a polymer material such as polyimide. In further implementations, the interposer 900 may be formed of alternate rigid or flexible materials that may include the same materials described above for use in a semiconductor substrate, such as silicon, germanium, and other group III-V and group IV materials.

The interposer 900 may include metal interconnects 908 and vias 910, including but not limited to through-silicon vias (TSVs) 912. The interposer 900 may further include embedded devices 914, including both passive and active devices. Such devices include, but are not limited to, capacitors, decoupling capacitors, resistors, inductors, fuses, diodes, transformers, sensors, and electrostatic discharge (ESD) devices. More complex devices such as radiofrequency (RF) devices, power amplifiers, power management devices, antennas, arrays, sensors, and MEMS devices may also be formed on the interposer 900. In accordance with embodiments of the invention, apparatuses or processes disclosed herein may be used in the fabrication of interposer 900.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. Rather, the scope of the invention is to be determined entirely by the following claims, which are to be construed in accordance with established doctrines of claim interpretation.

## Claims

1. An electrostatic discharge, ESD, protection apparatus comprising:
a first diode (344) with a first side and a second side opposite the first side, the first side of the first diode (344) electrically coupled with a voltage drain drain, Vdd (304);
a second diode (346) with a first side and a second side opposite the first side, the second side of the second diode (346) electrically coupled with a voltage source source, Vss (306);
an electrical pad (308);
an electrical circuit (302) protected by the ESD apparatus, the circuit (302) electrically coupled with the second side of the first diode (344), the first side of the second diode (346), and the electrical pad (308); and
wherein the first diode (344) and the second diode (346) are between a metal 2 layer (372) and a metal 4 layer (374) of a substrate and **characterised in that**
the first diode (344) and the second diode (346) have a first metal layer (490) of tellurium, TE, a semiconductor layer (492) of amorphous silicon, and a second metal layer (494) of beryllium, BE.

2. The apparatus of claim 1, wherein the first side of the first diode (344) and the first side of the second diode (346) are cathode sides, and wherein the second side of the first diode (344) and the second side of the second diode (346) are anode sides.

3. The apparatus of claim 1, wherein the electrical circuit (302) includes a plurality of transistors.

4. The apparatus of claim 1, wherein the first diode (344) and the second diode (346) are metal-semiconductor-metal, MSM, diodes.

5. The apparatus of claim 1, wherein the first diode (344) and the second diode (346) include a selected one or more of: titanium, nickel, or amorphous silicon.

6. The apparatus of claim 1, wherein the first diode (344) and the second diode (346) include a via or plug connection.

7. The apparatus of claim 1, wherein the electrical pad (308) is an input/output, I/O, pad.

8. The apparatus of claim 1, wherein at least a portion of the electrical circuit (302) is in a portion of the substrate.

9. The apparatus of claim 8, wherein the portion of the substrate is a front end of line, FEOL, portion of the substrate.

10. A method of forming an ESD protection apparatus comprising:
forming a first diode (344) and a second diode (346) between metal layer 2 and metal layer 4 of a substrate;
electrically coupling an anode of the first diode (344) with a cathode of the second diode (346);
electrically coupling an input/output, I/O, pad with the anode of the first diode (344);
electrically coupling a cathode of the first diode (344) to a Vdd (304); and
electrically coupling an anode of the second diode (346) to a Vss (306) **characterized in that** the first diode (344) and the second diode (346) have a first metal layer (490) of tellurium, TE, a semiconductor layer (492) of amorphous silicon, and a second metal layer (494) of beryllium, BE.

11. The method of claim 10, further comprising electrically coupling an electrical circuit (302) to the anode of the first diode (344) and a cathode of the second diode (346).

## Patentansprüche

1. Einrichtung zum Schutz vor elektrostatischer Entladung, ESD, die Folgendes umfasst:
eine erste Diode (344) mit einer ersten Seite und einer zweiten Seite gegenüber der ersten Seite, wobei die erste Seite der ersten Diode (344) elektrisch mit einer Spannung-Drain-Drain, Vdd (304), gekoppelt ist;
eine zweite Diode (346) mit einer ersten Seite und einer zweiten Seite gegenüber der ersten Seite, wobei die zweite Seite der zweiten Diode (346) elektrisch mit einer Spannung-Source-Source, Vss (306), gekoppelt ist;
ein elektrisches Pad (308);
eine elektrische Schaltung (302), die durch die ESD-Einrichtung geschützt wird, wobei die Schaltung (302) elektrisch mit der zweiten Seite der ersten Diode (344), der ersten Seite der zweiten Diode (346) und dem elektrischen Pad (308) gekoppelt ist; und
wobei sich die erste Diode (344) und die zweite Diode (346) zwischen einer Metall-2-Schicht (372) und einer Metall-4-Schicht (374) eines Substrats befinden und **dadurch gekennzeichnet sind, dass** die erste Diode (344) und die zweite Diode (346) eine erste Metallschicht (490) aus Tellur, TE, eine Halbleiterschicht (492) aus amorphem Silizium und eine zweite Metallschicht (494) aus Beryllium, BE, aufweisen.

2. Einrichtung nach Anspruch 1, wobei die erste Seite der ersten Diode (344) und die erste Seite der zweiten Diode (346) Kathodenseiten sind und wobei die zweite Seite der ersten Diode (344) und die zweite Seite der zweiten Diode (346) Anodenseiten sind.

3. Einrichtung nach Anspruch 1, wobei die elektrische Schaltung (302) eine Mehrzahl von Transistoren beinhaltet.

4. Einrichtung nach Anspruch 1, wobei die erste Diode (344) und die zweite Diode (346) Metall-Halbleiter-Metall- bzw. MSM-Dioden sind.

5. Einrichtung nach Anspruch 1, wobei die erste Diode (344) und die zweite Diode (346) ein oder mehrere ausgewählte von: Titan, Nickel oder amorphem Silizium beinhalten.

6. Einrichtung nach Anspruch 1, wobei die erste Diode (344) und die zweite Diode (346) eine Via- oder Stopfenverbindung beinhalten.

7. Einrichtung nach Anspruch 1, wobei das elektrische Pad (308) ein Eingabe/Ausgabe- bzw. E/A-Pad ist.

8. Einrichtung nach Anspruch 1, wobei sich mindestens ein Teil der elektrischen Schaltung (302) in einem Teil des Substrats befindet.

9. Einrichtung nach Anspruch 8, wobei der Teil des Substrats ein Front-End-Of-Line- bzw. FEOL-Teil des Substrats ist.

10. Verfahren zum Bilden einer ESD-Schutzeinrichtung, das Folgendes umfasst:
Bilden einer ersten Diode (344) und einer zweiten Diode (346) zwischen einer Metallschicht 2 und der Metallschicht 4 eines Substrats;
elektrisches Koppeln einer Anode der ersten Diode (344) mit einer Kathode der zweiten Diode (346);
elektrisches Koppeln eines Eingabe/Ausgabe- bzw. E/A-Pads mit der Anode der ersten Diode (344);
elektrisches Koppeln einer Kathode der ersten Diode (344) mit einem Vdd (304); und
elektrisches Koppeln einer Anode der zweiten Diode (346) mit einer Vss (306), **dadurch gekennzeichnet, dass** die erste Diode (344) und die zweite Diode (346) eine erste Metallschicht (490) aus Tellur, TE, eine Halbleiterschicht (492) aus amorphem Silizium und eine zweite Metallschicht (494) aus Beryllium, BE, aufweisen.

11. Verfahren nach Anspruch 10, ferner umfassend elektrisches Koppeln einer elektrischen Schaltung (302) mit der Anode der ersten Diode (344) und einer Kathode der zweiten Diode (346).

## Revendications

1. Appareil de protection contre les décharges électrostatiques, ESD, comprenant :
une première diode (344) avec un premier côté et un deuxième côté opposé au premier côté, le premier côté de la première diode (344) étant électriquement couplé à un drain de tension, Vdd (304) ;
une deuxième diode (346) avec un premier côté et un deuxième côté opposé au premier côté, le deuxième côté de la deuxième diode (346) étant électriquement couplé à une source de tension, Vss (306) ;
un plot de contact électrique (308) ;
un circuit électrique (302) protégé par l'appareil ESD, le circuit (302) étant couplé électriquement au deuxième côté de la première diode (344), au premier côté de la deuxième diode (346) et au plot de contact électrique (308) ; et
où la première diode (344) et la deuxième diode (346) sont entre une couche de métal 2 (372) et une couche de métal 4 (374) d'un substrat, et **caractérisées en ce que** la première diode (344) et la deuxième diode (346) ont une première couche métallique (490) de tellure, TE, une couche semi-conductrice (492) de silicium amorphe, et une deuxième couche métallique (494) de béryllium BE.

2. Appareil selon la revendication 1, dans lequel le premier côté de la première diode (344) et le premier côté de la deuxième diode (346) sont des côtés de type cathode, et dans lequel le deuxième côté de la première diode (344) et le deuxième côté de la deuxième diode (346) sont des côtés de type anode.

3. Appareil selon la revendication 1, dans lequel le circuit électrique (302) comprend une pluralité de transistors.

4. Appareil selon la revendication 1, dans lequel la première diode (344) et la deuxième diode (346) sont des diodes métal-semi-conducteur-métal, MSM.

5. Appareil selon la revendication 1, dans lequel la première diode (344) et la deuxième diode (346) comprennent un ou plusieurs éléments choisis parmi : le titane, le nickel ou le silicium amorphe.

6. Appareil selon la revendication 1, dans lequel la première diode (344) et la deuxième diode (346) comprennent une connexion par trou d'interconnexion ou plot de remplissage.

7. Appareil selon la revendication 1, dans lequel le plot de contact électrique (308) est un plot de contact d'entrée/sortie E/S.

8. Appareil selon la revendication 1, dans lequel au moins une partie du circuit électrique (302) se trouve dans une partie du substrat.

9. Appareil selon la revendication 8, dans lequel la partie du substrat est une partie de la portion avant de ligne, FEOL, du substrat.

10. Procédé de formation d'un appareil de protection ESD comprenant les étapes suivantes :
former une première diode (344) et une deuxième diode (346) entre la couche de métal 2 et la couche de métal 4 d'un substrat,
coupler électriquement une anode de la première diode (344) à une cathode de la deuxième diode (346),
coupler électriquement un plot de contact d'entrée/sortie, E/S, à l'anode de la première diode (344),
coupler électriquement une cathode de la première diode (344) à un Vdd (304) ; et
coupler électriquement une anode de la deuxième diode (346) à une Vss (306), ce qui est **caractérisé en ce que** la première diode (344) et la deuxième diode (346) ont une première couche métallique (490) de tellure, TE, une couche semi-conductrice (492) de silicium amorphe, et une deuxième couche métallique (494) de béryllium, BE.

11. Procédé selon la revendication 10, comprenant en outre le couplage électrique d'un circuit électrique (302) à l'anode de la première diode (344) et à une cathode de la deuxième diode (346).
